# EUROPÄISCHE PATENTSCHRIFT

(11) **EP 3 655 995 B1**
(45) Veröffentlichungstag und Bekanntmachung des Hinweises auf die Patenterteilung: **19.01.2022**
(21) Anmeldenummer: 18725467.7
(22) Anmeldetag: 15.05.2018
(51) Int. Cl.: H01L 31/0288, H01L 21/22, H01L 31/068, H01L 31/18

(54) **VERFAHREN ZUR HERSTELLUNG VON PERT SOLARZELLEN**
METHOD FOR PRODUCING PERT SOLAR CELLS
PROCÉDÉ DE FABRICATION DE CELLULES SOLAIRES PERT

(30) Priorität: 20.07.2017 DE 102017116419
(43) Veröffentlichungstag der Anmeldung: 27.05.2020
(73) Patentinhaber: International Solar Energy Research Center Konstanz E.V., 78467 Konstanz (DE)
(72) Erfinder: BUCHHOLZ, Florian, 78462 Konstanz (DE); PREIS, Pirmin, 78462 Konstanz (DE); PETER, Christoph, 78467 Konstanz (DE)
(74) Vertreter: Westphal, Mussgnug & Partner Patentanwälte mbB
(86) Internationale Anmeldenummer: PCT/EP2018/062551
(87) Internationale Veröffentlichungsnummer: WO 2019/015827

(56) Entgegenhaltungen:
- CN-A- 102 315 284
- DE-A1-102011 086 351
- DE-A1-102012 107 372

## Beschreibung

PERT (passivated emitter and rear, totally diffused)-Solarzellen sind eine bekannte Gattung von Solarzellen. Sie weisen sowohl auf der Vorder- als auch auf der Rückseite vollflächig hoch dotierte Bereiche (p+/n+) auf. Diese werden in der Regel durch die Diffusion eines Dotierstoffes, wie Phosphor, Bor, Arsen oder Antimon aus geeigneter Quelle bei erhöhter Temperatur hergestellt. Es ist aber auch die Einbringung einen Dotierstoffes durch Implantation, sowie das epitaktisches Wachstum von einkristallinen oder die Abscheidung von amorphen oder polykristallinen hochdotieren Silizum-Schichten durch CVD Prozess möglich. So genannte PERPoly (Passivated Emitter Rear Polysilicon contact)Solarzellen, und Solarzelle mit POLO oder TopCON - Kontakt, bei denen eine hochdotierte Silizium- oder Siliziumcarbit- oder eine andere halbleitende Schicht durch eine dünne Interfaceschicht, oft aus Siliziumoxid oder Aluminiumoxid vom Substrat separiert werden, rechnen wir dabei explizit zur Gattung der PERT Zellen hinzu.

Das Basismaterial der PERT-Zelle kann dabei sowohl n- als auch p-dotiertes Silizium oder ein anderes halbleitendes Material sein, und es kann sich auf der Vorderseite, also auf der Seite des hauptsächlichen Lichteinfalles, sowohl der n+ als auch p+-dotierte Bereich befinden.

Ein Problem dieser Solarzellenart besteht aber darin, dass während des Herstellungsprozesses aneinander angrenzende, entgegengesetzt hochdotierte (p+/n+) Bereiche am Rand der Solarzelle entstehen, die zu geringen Shuntwiderständen und zu geringer Durchbruchspannung der Solarzelle führen. Dies hat zur Folge, dass unter Rückwärtsbelastung (reverse bias), die z.B. auftritt, wenn einzelne Solarzellen in einem Solarmodul abgeschattet werden, der gesamte Strom des jeweiligen Strings in Sperrrichtung der Diode durch die betroffene Solarzelle fließt, wodurch es zu großen lokalen Energiedichten und somit Wärmeentwicklung, auch als Hot-Spot Bildung bezeichnet, kommen kann. Eine solche Wärmeentwicklung kann zur Beschädigung der Solarzelle und des gesamten Solarmoduls führen.

Wird beispielsweise ein kritischer Wert für den so genannten Rückwärtsstrom von ca. 1 Ampere bei einer anliegenden Spannung von -12 Volt überschritten, kann es zu einer starken Wärmeentwicklung kommen, so dass im Betrieb Temperaturen von >100°C auftreten können, was zur Beschädigung von Modulkomponenten, insbesondere des im Modul eingesetzten Verkapselungsmaterials (z.B. EVA oder POE) und der Rückseitenfolie führen kann.

Aus diesem Grund sind viele Hersteller von PERT-Zellen dazu übergegangen, als letzten Prozessschritt bei der Herstellung derartiger Solarzellen eine Laser-Kantenisolation durchzuführen. Dabei wird auf der Emitterseite der Solarzelle, also bei der Seite, die entgegengesetzt zum Wafer dotiert ist, mit Hilfe eines Lasers ein einige µm tiefer Graben in der Solarzelle erzeugt; das dort befindliche Silizium wird durch den Laser entfernt. Der Lasergraben wird in einem Abstand von wenigen hundert µm von der Kante erzeugt. Der Solarzellen-Emitter, oft auf der Vorderseite der Solarzelle hat normalerweise eine Tiefe < 1-2 pm, so dass der Lasergraben den Solarzellen-Emitter von der entgegengesetzt dotierten Seite trennt. Durch die Trennung kann eine hohe Durchbruchspannung der Solarzelle erreicht werden, weswegen sie selbst unter reverse bias-Bedingungen keinen erheblichen Stromfluss in Sperrrichtung zulässt, wobei kein erheblicher Stromfluss im Sinne dieser Beschreibung dann vorliegt, wenn der Rückwärtsstrom bei einer anliegenden negativen Spannung von -12 Volt kleiner als 1 Ampere ist. Der Shuntwiderstand kann auf diese Weise auf Werte > 100 Ohm gesteigert werden.

Diese Vorgehensweise bringt allerdings zwei gravierende Nachteile mit sich: Erstens wird die aktive Fläche der Solarzelle verringert, da Ladungsträger, die in Randbereich außerhalb des Grabens erzeugt werden nicht oder nur noch geringfügig zum Strom der Solarzelle beitragen können. Zweitens hinterlässt der Laser einen erheblichen Schaden an der Oberfläche der Solarzelle, die gelaserte Fläche ist nicht mehr passiviert und stattdessen ein Ort sehr hoher Rekombination, was zu einer Erhöhung des Sperrsättigungsstromes und damit zu einer Verringerung des Füllfaktors führt. Beide Effekte führen zusammen zu einem Verlust von 0,2% absolut im Wirkungsgrad für PERT Solarzellen mit Laser-Kantenisolation im Vergleich zu unbehandelten Solarzellen des gleichen Typs.

Ein alternativer, aber wenig verbreiteter Ansatz zur Kantenisolation besteht darin, Vorder- und Rückseite der Solarzelle durch einen Plasma-Ätzschritt nach Erstellung der hochdotierten Bereiche voneinander zu trennen. Dabei wird mittels eines Plasmas am Rand der Solarzelle die dort vorliegende dotierte Silizium-Schicht abgeätzt und somit die Trennung von Vorder- und Rückseite herbeigeführt. Auch das Plasmaätzen ist mit erheblichen Nachteilen verbunden, da es sich um einen teuren Prozessschritt handelt dazu kommt, dass die Wafer für diesen Schritt gestapelt werden müssen, so dass der Ausschuss durch mechanische Schädigung und Bruch gesteigert wird.

In der Solarzellentechnologie finden auch nasschemische Ätzverfahren zur Kantenisolation bereits Verwendung, bei denen insbesondere, wie z.B. aus der DE 10 2009 050 845 A1 bekannt, eine Substratoberfläche des Substrats durch eine Wasserkappe geschützt sein kann. Diese Verfahren können allerdings bislang nur für sogenannte Al-BSF, MWT und PERC-Solarzellen verwendet werden, weil sie mit sich bringen, dass eine der dotierten Oberflächen der Solarzelle, im Regelfall die Rückseite, durch die Ätzflüssigkeit weggeätzt wird. Eine Möglichkeit, ein solches Verfahren insbesondere bei PERT Solarzellen zu verwenden ist bisher nicht gefunden worden.

Aus der CN 102315284 A ist ein Verfahren zur Herstellung von Solarzellen mit den Schritten
- Bereitstellen eines n- oder p-dotierten Siliziumsubstrats,
- Ausführen eines Erstdotierungsprozesses, mit dem zumindest eine Seite des n- oder p-dotierten Siliziumsubstrats dotiert wird oder mindestens eine dotierte Schicht auf eine Seite des N- oder P- dotierten Siliziumsubstrats aufgebracht wird, um eine erstdotierte Seite zu schaffen,
- Abscheiden mindestens einer die Oberfläche passivierenden oder die Oberfläche maskierenden Substanz auf der erstdotierten Seite der Solarzelle,
- Ausführen eines zweiten Dotierungsprozesses, mit dem zumindest die andere, der erstdotierten Seite gegenüberliegende Seite des n- oder p-dotierten Siliziumsubstrats dotiert oder eine dotierte Schicht auf dieser aufgebracht wird, und
- Ausführung chemischer Ätzprozesse nach der Ausführung dieser Schritte, nämlich einseitiges Ätzen der Emitterschicht und Ätzen von PSG-Schicht und Si02-Schichten.

Die Druckschrift CN 105 742 411 B beschreibt ein Verfahren zur Herstellung von Solarzellen mit den Schritten:
- Bereitstellen eines n- oder p-dotierten Siliziumsubstrats,
- Ausführen eines ersten Dotierungsprozesses, mit dem zumindest eine Seite des n- oder p-dotierten Siliziumsubstrats dotiert wird oder mindestens eine dotierte Schicht auf eine Seite des n- oder p-dotierten Siliziumsubstrats aufgebracht wird, um eine erstdotierte Seite zu schaffen,
- Abscheiden mindestens einer die Oberfläche passivierenden oder die Oberfläche maskierenden Substanz zumindest auf der erstdotierten Seite der Solarzelle,
- Ausführen eines zweiten Dotierungsprozesses, mit dem zumindest die andere, der erstdotierten Seite gegenüberliegende Seite des n- oder p-dotierten Siliziumsubstrats dotiert, oder eine dotierte Schicht auf sie aufgebracht wird,
- nach Ausführung dieser Schritte Ausführung des nasschemischen Ätzens der Kanten der Solarzelle.

Die Aufgabe der Erfindung besteht daher darin, ein Verfahren zur Herstellung von PERT Solarzellen bereitzustellen, das eine nasschemische Kantenisolation ermöglicht. Diese Aufgabe wird gelöst durch ein Verfahren zur Herstellung von PERT-Solarzellen mit den Merkmalen des Patentanspruchs 1. Vorteilhafte Weiterbildungen des Verfahrens sind Gegenstand der abhängigen Ansprüche.

Das erfindungsgemäße Verfahren zur Herstellung von PERT Solarzellen weist, wie bereits bekannte Verfahren zur Herstellung dieser Art von Solarzellen die Schritte
- Bereitstellen eines n-oder p-dotierten Siliziumsubstrats,
- Ausführen eines ersten Dotierungsprozesses, mit dem zumindest eine erste Seite (im Folgenden als erstdotierte Seite bezeichnet) -bevorzugt zumindest die Rückseite- der PERT Solarzelle dotiert wird, um eine erstdotierte Seite zu schaffen oder mindestens eine dotierte Schicht aufgebracht wird, um eine erstdotierte Seite zu schaffen.

Dabei kann die mindestens eine aufgebrachte dotierte Schicht auch Bestandteil eines Schichtstapels aus passivierenden und leitenden Schichten sein kann. Insbesondere wird in diesem ersten Dotierungsschritt die entsprechende Seite der PERT Solarzelle bevorzugt hoch dotiert, wobei unter "hoch dotiert" im Kontext dieser Beschreibung eine Dotierung von mindestens 10¹⁹ Dotieratomen/cm³ zu verstehen ist.
- Abscheiden mindestens einer die Oberfläche passivierenden oder die Oberfläche maskierenden Substanz zumindest auf der erstdotierten Seite der PERT Solarzelle, und
- Ausführen eines zweiten Dotierungsprozesses, mit dem zumindest die andere, der erstdotierten Seite gegenüberliegende Seite, bevorzugt die Vorderseite des p- oder n-dotierten Siliziumsubstrats dotiert wird, auf. Auch dieser Dotierungsprozess führt bevorzugt zu einer hohen Dotierung im vorstehend definierten Sinne von "hoch dotiert".

Diese Schritte werden in der angegebenen Reihenfolge, aber nicht zwingend unmittelbar nacheinander ausgeführt. Hinzuweisen ist in diesem Zusammenhang darauf, dass durch die Verwendung der Formulierungen "Ausführen eines ersten Dotierungsprozesses" und "mindestens eine die Oberfläche passivierende oder die Oberfläche maskierende Substanz" insbesondere auch PERT Solarzellen mit Passivierungs- und Maskierungsstacks dem Anspruch unterfallen, wie sie z.B. bei solchen Solarzellen mit passiviertem Kontakt, POLO oder PERPOLY oder TOPCON verwendet werden.

Erfindungswesentlich ist, dass nach der Ausführung dieser Schritte die Kanten der PERT Solarzelle nasschemisch geätzt werden, wobei bei dem nasschemischen Ätzen die andere, der erstdotierten Seite gegenüberliegende Seite der Solarzelle bzw. des p- oder n- dotierten Siliziumsubstrats, aus dem bei der Durchführung des Verfahrens die Solarzelle entsteht, d.h. bevorzugt die spätere Vorderseite der PERT Solarzelle, durch eine Wasserkappe geschützt wird.

Die nasschemische Ätzung der Kanten wird insbesondere dadurch ermöglicht, dass die die Oberfläche passivierende oder die Oberfläche maskierende Substanz sinterbar ist und dass nach dem Abscheiden einer die Oberfläche passivierenden oder die Oberfläche maskierenden Substanz zumindest auf der erstdotierten Seite der PERT Solarzelle bzw. des p- oder n- dotierten Siliziumsubstrats, aus dem bei der Durchführung des Verfahrens die Solarzelle entsteht, und vor dem nasschemischen Ätzen der Kanten die auf der erstdotierten Seite der PERT Solarzelle bzw. des p- oder n- dotierten Siliziumsubstrats, aus dem bei der Durchführung des Verfahrens die Solarzelle entsteht, abgeschiedene, die Oberfläche passivierende oder die Oberfläche maskierende Substanz durch eine Hochtemperaturbehandlung gesintert wird, so dass sie durch die Ätzflüssigkeit, mit der das nasschemische Ätzen der Kanten erfolgt, nicht angegriffen wird oder weniger stark angegriffen wird als die Kanten der PERT Solarzelle, selbst wenn diese parasitär beim Abscheiden einer die Oberfläche passivierenden oder die Oberfläche maskierenden Substanz zumindest auf der erstdotierten Seite der PERT Solarzelle abgeschiedene, die Oberfläche passivierende oder die Oberfläche maskierende Substanz aufweisen.

Auf diese Weise kann eine Kantenisolation, bei der die Wafer nicht geschädigt werden, realisiert werden, die zudem mit deutlich höheren Durchsätzen als Lasersysteme oder Plasmaätzanlagen erlauben umgesetzt werden kann und wegen des geringen Ätzvolumens lediglich einen äußerst geringen Chemikalienverbrauch mit sich bringt.

Anzumerken ist, dass in dieser Offenbarung stellenweise Begriff "PERT"-Solarzelle um eine höhere Klarheit und Knappheit der Formulierung zu erzielen teilweise auch für Zwischenprodukte (Zellvorläufer), aus denen bei der Durchführung des Verfahrens eine solche Zelle wird, verwendet wird.

Ein bevorzugtes Material für eine solche sinterbare Substanz ist zum Beispiel Siliziumnitrid, ein anderes vorteilhaft verwendbares Material Siliziumcarbid.

Besonders ökonomisch lässt sich das Verfahren ausführen, wenn die Hochtemperaturbehandlung beim Ausführen eines Diffusionsschritts beim zweiten Dotierungsprozess und somit zeitlich parallel zu diesem ohnehin notwendigen Schritt erfolgt.

Eine andere ökonomisch Vorgehensweise für die Hochtemperaturbehandlung besteht darin, dass sie beim Ausführen eiens notwendigen Annealingprozesses beim zweiten Dotierungsprozess erfolgt.

Besonders bewährt haben sich Hochtemperaturbehandlungen, bei denen die PERT Solarzelle (d.h. genauer gesagt die spätere PERT Solarzelle, die gerade hergestellt wird) bei der Hochtemperaturbehandlung einer Temperatur von mindestens 500°C, bevorzugt mehr als 700°C für eine Zeitspanne von mindestens einer Sekunde ausgesetzt wird. Es reicht also bereits ein kurzes "Feuern" bei diesen hohen Temperaturen aus.

Besonders bewährt hat es sich, wenn die Ätzflüssigkeit ein Gemisch aus HF, HNO₃ und H₂SO₄ ist. Bevorzugt ist dabei ein Volumenanteil von HF in dem Gemisch, der zwischen 5% und 40% liegt und somit höher ist als in sonst üblichen Ätzflüssigkeiten auf der Basis dieser Substanzen.

Mit dem Abscheiden der die Oberfläche passivierenden oder die Oberfläche maskierenden Substanz zumindest auf der erstdotierten Seite der PERT Solarzelle kann es in Abhängigkeit von den Anforderungen an die abgeschiedene Schicht dazu kommen, dass die Substanz parasitär auch an den Kanten abgeschieden wird, wobei die Menge der parasitären Abscheidung von der Rückseite zur Oberseite hin abnimmt. Selbst in Fällen, in denen diese parasitäre Abscheidung so stark ist, dass eine Hochtemperaturbehandlung auch an den Kanten zu einer vollständigen Sinterung des die Oberfläche passivierenden oder maskierenden Materials käme, kann die Erfindung aber dennoch angewendet werden, wenn zwischen dem Abscheiden der die Oberfläche passivierenden oder die Oberfläche maskierenden Substanz zumindest auf der Rückseite der PERT Solarzelle und dem Sintern der die Oberfläche passivierenden oder die Oberfläche maskierenden Substanz durch Hochtemperaturbehandlung weitere, insbesondere nasschemische Prozessschritte erfolgen, bei denen Teile der die Oberfläche passivierenden oder die Oberfläche maskierenden Substanz entfernt werden.

Dies kann insbesondere dadurch ermöglicht werden, dass oftmals ohnehin vorgesehene Prozessschritte wie z.B. eine Oberflächentexturierung des n-dotierten Siliziumsubstrats und/oder ein Bor- bzw. Phosphorglasätzen hinsichtlich der Prozessdauer und/oder der Konzentrationen der verwendeten Chemikalien angepasst werden. Auf diese Weise kann im Bedarfsfall, d.h. insbesondere dann, wenn die erwünschte Schichtdicke der die Oberfläche passivierenden oder maskierenden Substanz so hoch ist, dass die parasitäre Beschichtung der Kanten ebenfalls durch thermische Behandlung zu einer Ätzbarriere würde, verhindert werden, dass durch die Hochtemperaturbehandlung auch parasitäre Beschichtung an den Kanten gesintert wird und dann nicht mehr nasschemisch geätzt werden kann.

Als vorteilhaft hat sich ferner erwiesen, wenn vor der Aufbringung der dotierten Schicht auf der Rückseite der PERT-Solarzelle eine -bevorzugt dünn ausgestaltete- Oxidschicht aufgebracht wird.

Die Erfindung wird nachfolgend anhand einer Figur näher erläutert. Es zeigt:

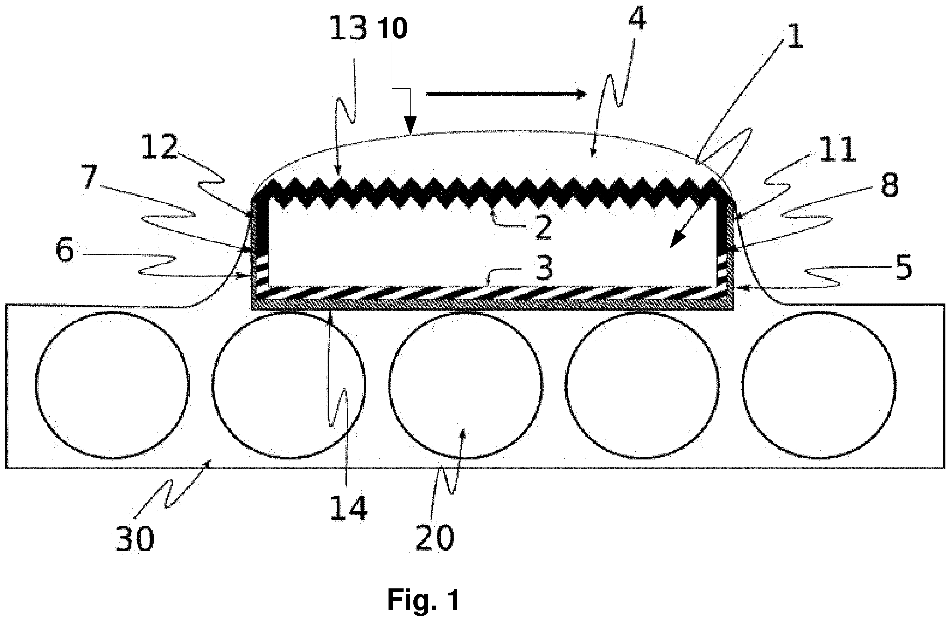

- Fig. 1:: eine schematische Darstellung eines nasschemischen Kantenätzschritts bei der Herstellung einer PERT Solarzelle.

In der schematischen Darstellung der Figur 1 erkennt man eine Solarzelle 10 (bzw. genauer gesagt deren Vorläufer), die mittels Transportrollen 20 in der durch den Pfeil angegebenen Richtung durch ein Ätzbad mit einer durch eine Mischung von HF, HNO₃ und H₂SO₄ gebildeten Ätzflüssigkeit 30 gefahren wird, um eine nasschemische Ätzung der Kanten 11,12 der PERT Solarzelle 10 zu bewirken.

Die PERT Solarzelle 10 hat in diesem Beispiel ein n-dotiertes Siliziumsubstrat 1, einen an der Vorderseite 13 des Siliziumsubstrats 1 ausgebildeten, p+-dotierten Emitter 2 und ein an der Rückseite 14 des Siliziumsubstrats 1 ausgebildetes, n+-dotiertes Back-surface-field 3. Die Vorderseite 13 des Siliziumsubstrats 1 kann optional strukturiert sein. Die Rückseite 14 des Siliziumsubstrats 1 kann optional entweder poliert oder strukturiert sein.

Während des dargestellten nasschemischen Ätzprozesses ist die Vorderseite 13 durch eine Wasserkappe 4 geschützt, während die Rückseite 14 durch eine gesinterte Schicht einer die Oberfläche passivierendem oder die Oberfläche maskierenden Substanz 5, konkret z.B. eine Siliziumnitridschicht oder einen Stack aus Siliziumoxid und Siliziumnitridschichten geschützt ist. Auf diese Weise können parasitär abgelagerte Reste 6 von der die Oberfläche passivierendem oder die Oberfläche maskierendem Substanz 5 - konkret z.B. parasitäre Siliziumnitridablagerungen an den Kanten 11,12-, das zum Zeitpunkt der Hochtemperaturbehandlung, die das Versintern bewirkt hat, dort nicht oder nicht mehr in zur Ausbildung einer geschlossenen Ätzbarriere ausreichender Konzentration vorlagen und Kantenbereiche 7,8 des Siliziumsubstrats 1, in denen sich Bereiche unterschiedlicher Dotierung berühren, weggeätzt und so eine nasschemische Kantenisolation erreicht werden.

Wie dem Fachmann unmittelbar klar ist, ist das hier beschriebene Ausführungsbeispiel nicht auf n-dotierte Substrate und die angegebenen Dotierungen insbesondere des Emitters und zur Schaffung des Back-surface-fields beschränkt, sondern unmittelbar auf anders dotierte hoch dotierte Bereiche übertragbar.

### Bezugszeichenliste

- 1: n-dotiertes Siliziumsubstrat
- 2: p+-dotierter Emitter
- 3: n+-dotiertes back surface field
- 4: Wasserkappe
- 5: die Oberfläche passivierende oder die Oberfläche maskierende Substanz
- 6: parasitär die Oberfläche passivierende oder die Oberfläche maskierende Substanz
- 7,8: Kantenbereich, in dem sich Bereiche unterschiedlicher Dotierung berühren

- 10: PERT Solarzelle (bzw. deren Vorläuferstruktur)

- 11,12: Kante
- 13: Vorderseite des Substrats
- 14: Rückseite des Substrats
- 20: Transportrolle
- 30: Ätzflüssigkeit

## Patentansprüche

1. Verfahren zur Herstellung von PERT Solarzellen (10) mit den Schritten
- Bereitstellen eines n- oder p-dotierten Siliziumsubstrats (1),
- Ausführen eines ersten Dotierungsprozesses, mit dem zumindest eine Seite des n- oder p-dotierten Siliziumsubstrats (1) dotiert wird oder mindestens eine dotierte Schicht auf eine Seite des n- oder p-dotierten Siliziumsubstrats (1)aufgebracht wird, um eine erstdotierte Seite zu schaffen,
- Abscheiden mindestens einer die Oberfläche passivierenden oder die Oberfläche maskierenden Substanz (5) zumindest auf der erstdotierten Seite der PERT Solarzelle (10),
- Ausführen eines zweiten Dotierungsprozesses, mit dem zumindest die andere, der erstdotierten Seite gegenüberliegende Seite des n- oder p-dotierten Siliziumsubstrats (1) dotiert, oder eine dotierte Schicht auf sie aufgebracht wird
- wobei nach der Ausführung dieser Schritte die Kanten (11,12) der PERT Solarzelle (10) nasschemisch geätzt werden, **dadurch gekennzeichnet, dass** bei dem nasschemischen Ätzen die andere, der erstdotierten Seite gegenüberliegende Seite der PERT Solarzelle (10) durch eine Wasserkappe (4) geschützt wird, dass die die Oberfläche passivierende oder die Oberfläche maskierende Substanz (5) sinterbar ist und dass nach dem Abscheiden einer die Oberfläche passivierenden oder die Oberfläche maskierenden Substanz (5) zumindest auf der erstdotierten Seite der PERT Solarzelle (10) und vor dem nasschemischen Ätzen der Kanten (11,12) die auf der erstdotierten Seite der PERT Solarzelle (10) abgeschiedene, die Oberfläche passivierende oder die Oberfläche maskierende Substanz (5) durch eine Hochtemperaturbehandlung gesintert wird, so dass sie durch die Ätzflüssigkeit(30), mit der das nasschemische Ätzen der Kanten (11,12) erfolgt, nicht oder weniger stark angegriffen wird als die Kanten (11,12) der PERT Solarzelle (10), selbst wenn diese parasitär beim Abscheiden einer die Oberfläche passivierenden oder die Oberfläche maskierenden Substanz (5) zumindest auf der erstdotierten Seite der PERT Solarzelle (10) abgeschiedene, die Oberfläche passivierende oder maskierende Substanz (5) aufweisen.

2. Verfahren nach Anspruch 1,
**dadurch gekennzeichnet, dass** die Hochtemperaturbehandlung beim Ausführen eines Diffusionsschritts beim zweiten Dotierungsprozess erfolgt.

3. Verfahren nach Anspruch 1,
**dadurch gekennzeichnet, dass** die Hochtemperaturbehandlung beim Ausführen eines notwendigen Annealingprozesses beim zweiten Dotierungsprozess erfolgt.

4. Verfahren nach Anspruch 1,2 oder 3,
**dadurch gekennzeichnet, dass** die PERT Solarzelle (10) bei der Hochtemperaturbehandlung einer Temperatur von mindestens 500°C für eine Zeitspanne von mindestens 1 Sekunde ausgesetzt wird.

5. Verfahren nach einem der vorstehenden Ansprüche,
**dadurch gekennzeichnet, dass** die Ätzflüssigkeit (30) ein Gemisch aus HF, HNO₃ und H₂SO₄ ist oder mindestens eine der Komponenten HF, HNO₃ und H₂SO₄ enthält.

6. Verfahren nach Anspruch 5,
**dadurch gekennzeichnet, dass** der Volumenanteil von HF in der Ätzflüssigkeit (30) zwischen 5% und 40% liegt.

7. Verfahren nach einem der vorstehenden Ansprüche,
**dadurch gekennzeichnet, dass** zwischen dem Abscheiden der die Oberfläche passivierenden oder die Oberfläche maskierenden Substanz (5) zumindest auf der erstdotierten Seite der PERT Solarzelle (10) und dem Sintern der die Oberfläche passivierenden oder die Oberfläche maskierenden Substanz (5) durch Hochtemperaturbehandlung weitere Prozessschritte erfolgen, bei denen Teile der die Oberfläche passivierenden oder die Oberfläche maskierenden Substanz (5) entfernt werden.

8. Verfahren nach einem der vorstehenden Ansprüche,
**dadurch gekennzeichnet, dass** vor der Aufbringung der dotierten Schicht zur Schaffung der erstdotierten Seite auf der erst zu behandelnden Rückseite(14), der PERT-Solarzelle (10) eine Oxidschicht aufgebracht wird.

## Claims

1. Method for the manufacture of PERT solar cells (10) with the steps
- providing a n-doped or a p-doped silicon substrate (1),
- carrying out a first doping process, by which at least one side of the n- or p-doped silicon substrate (1) is doped or at least one doped layer is applied to one side of the n- or p-doped silicon substrate (1) in order to produce a firstly doped side,
- depositing, at least on the firstly doped side of the PERT solar cell (10), a substance (5) which passivates the surface or which masks the surface,
- carrying out a second doping process, by which at least the other side of the n- or p-doped substrate, lying opposite the firstly doped side, is doped, or by which a doped layer is applied onto this layer,
wherein, after carrying out these steps, the edges (11, 12) of the PERT solar cell (10) are wet-chemically etched,
**characterized in that**
during the wet-chemical etching, the other, firstly doped side of the PERT solar cell (10) that lies opposite is protected by a water cap (4),
**in that** the substance (5) which passivates the surface or that masks the surface can be sintered, and
**in that**, after depositing a surface-passivating or a surface-masking substance (5) on at least the firstly doped side of the PERT solar cell (10) and before the wet-chemical etching of the edges (11, 12), the surface-passivating or a surface-masking substance (5) deposited on the firstly doped side of the PERT solar cell is sintered by means of a high-temperature treatment such that it is not corroded by the etching fluid (30) by means of which the wet-chemical etching of the edges (11, 12) is carried out, or is corroded to a lesser degree than the edges (11, 12) of the PERT solar cell (10), even if the latter parasitically exhibits the surface-passivating or surface-masking substance (5) upon depositing onto at least the firstly doped side of the PERT solar cell (10) the substance (5) which passivates or masks the surface.

2. Method in accordance with claim 1,
**characterized in that** the high-temperature treatment is conducted while carrying out a diffusion step during the second doping process.

3. Method in accordance with claim 1,
**characterized in that** the high-temperature treatment is conducted while carrying out a required annealing process during the second doping process.

4. Method in accordance with claim 1, 2 or 3,
**characterized in that** the PERT solar cell (10) is exposed to a temperature of at least 500° C for a time period of at least 1 second during the high-temperature treatment.

5. Method in accordance with any of the preceding claims,
**characterized in that** the etching fluid (30) is a mixture of HF, HNO₃ and H₂SO₄ or **in that** it contains at least one of the components HF, HNO₃ and H₂SO₄.

6. Method in accordance with claim 5,
**characterized in that** the proportion by volume of HF in the etching fluid (30) lies between 5% and 40%.

7. Method in accordance with any of the preceding claims,
**characterized in that**, between depositing the surface-passivating or the surface-masking substance (5) on at least the firstly doped side of the PERT solar cell (10) and the sintering of the surface-passivating or the surface-masking substance (5) by means of high-temperature treatment, further process steps follow during which parts of the surface-passivating or the surface-masking substance (5) are removed.

8. Method in accordance with any of the preceding claims,
**characterized in that**, before applying the doped layer in order to create the firstly doped side on the backside (14) to be treated first, an oxidation layer is applied onto the PERT solar cell.

## Revendications

1. Procédé de fabrication de cellules solaires PERT (10) comprenant les étapes suivantes consistant à :
- fournir un substrat (1) de silicium à dopage n ou p,
- effectuer une première opération de dopage en dopant au moins un côté du substrat (1) de silicium à dopage n ou p ou en appliquant au moins une couche dopée sur un côté du substrat (1) en silicium, à dopage n ou p pour y créer un côté ayant un premier dopage,
- déposer au moins une substance de masquage (5) sur la surface à passiver ou la surface à masquer, au moins sur le côté à premier dopage de la cellule solaire PERT (10),
- effectuer une seconde opération de dopage pour doper au moins l'autre côté à l'opposé du côté à premier dopage du substrat de silicium (1) à dopage n ou p ou pour appliquer sur celle-ci une couche dopée, selon lequel, et
- après avoir effectué ces étapes, on effectue une gravure par chimie en voie humide des arêtes (11, 12) de la cellule solaire PERT (10),
procédé **caractérisé en ce que**
- pendant la gravure par chimie en voie humide, on protège l'autre face de la cellule solaire PERT (10), ayant le premier dopage par un bonnet de protection contre l'eau (4),
- la substance (5) passivant la surface ou masquant la surface peut être frittée, et
- après le dépôt d'une substance (5) qui passive la surface ou qui masque la surface au moins sur le côté à premier dopage de la cellule solaire PERT (10) et avant la gravure par chimie en voie humide des arêtes (11, 12), on frite la substance (5) déposée sur le côté à premier dopage de la cellule solaire PERT (10) et passivant ou masquant la surface, par un traitement à haute température de façon qu'elle ne soit pas attaquée ou moins fortement attaquée par le liquide de gravure (30) concernant la gravure par chimie en voie humide des arêtes (11, 12) pour ne pas être attaquée ou moins fortement attaquée que les arêtes (11, 12) de la cellule solaire PERT (10), même si elles ont cette substance (5) déposée parasitairement, lors du dépôt d'une substance (5) passivant la surface ou masquant la surface au moins sur le côté à premier dopage de la cellule solaire PERT (10) et passivant ou masquant la surface.

2. Procédé selon la revendication 1,
**caractérisé en ce que**
le traitement à haute température se fait pendant l'exécution d'une étape de diffusion au cours d'une seconde opération de dopage.

3. Procédé selon la revendication 1,
**caractérisé en ce que**
le traitement à haute température se fait pendant l'exécution d'une étape de diffusion au cours d'une seconde opération de dopage.

4. Procédé selon les revendications 1, 2 ou 3,
**caractérisé en ce que**
la cellule solaire PERT (10) est exposée à un traitement à haute température à une température d'au moins 500°C pour une durée d'au moins 1 seconde.

5. Procédé selon l'une des revendications précédentes,
**caractérisé en ce que**
le liquide de gravure (30) est un mélange de HF, HNO₃ et H₂SO₄ ou contenant au moins l'un des composants HF, HNO₃ et H₂SO₄.

6. Procédé selon la revendication 5,
**caractérisé en ce que**
la teneur en volume de HF dans le liquide de gravure (30) est comprise entre 5% et 40%.

7. Procédé selon l'une des revendications précédentes,
**caractérisé en ce que**
entre le dépôt de la substance (5) qui passive la surface ou masque la surface, au moins sur le côté de la cellule solaire PERT (10) à premier dopage et le frittage de la substance (5) passivant la surface ou masquant la surface, par un traitement à haute température, on effectue d'autres opérations par lesquelles on enlève des parties de la substance (5) passivant la surface ou masquant la surface.

8. Procédé selon l'une des revendications précédentes,
**caractérisé en ce que**
avant l'application de la couche de dopage pour créer la face à premier dopage sur le côté arrière (14) premier à être traité, on applique une couche d'oxydes sur la cellule solaire PERT (10).
